(19) Europäisches Patentamt
European Patent Office
Office européen des brevets

(11) EP 0 483 669 B1

(12) **EUROPEAN PATENT SPECIFICATION**

(45) Date of publication and mention
of the grant of the patent:
**19.06.1996 Bulletin 1996/25**

(51) Int Cl.6: **C23C 16/50**, H01L 21/285,
H01L 21/768

(21) Application number: **91118166.7**

(22) Date of filing: **24.10.1991**

(54) **A method for forming a thin film and semiconductor devices**

Verfahren zur Herstellung einer dünnen Schicht und Halbleitervorrichtungen

Procédé de formation d'une couche mince et dispositifs semiconducteurs

(84) Designated Contracting States:
**DE FR GB NL**

(30) Priority: **24.10.1990 JP 287765/90**
**07.06.1991 JP 162365/91**

(43) Date of publication of application:
**06.05.1992 Bulletin 1992/19**

(73) Proprietor: **SUMITOMO METAL INDUSTRIES,**
**LTD.**
**Osaka 541 (JP)**

(72) Inventors:
• **Akahori, Takashi**
**Amagasaki, Hyogo 660 (JP)**
• **Tanihara, Akira**
**Souraku-gun, Kyoto 619-02 (JP)**

(74) Representative:
**TER MEER - MÜLLER - STEINMEISTER &**
**PARTNER**
**Mauerkircherstrasse 45**
**81679 München (DE)**

(56) References cited:
**US-A- 4 401 054**          **US-A- 4 800 176**

• **JOURNAL OF VACUUM SCIENCE AND**
**TECHNOLOGY: PART A. vol. 7, no. 1, January**
**1989, NEW YORK US pages 31 - 35 DONG HOON**
**JANG ET AL 'The deposition rate and properties**
**of the deposit in plasma enhanced chemical**
**vapor deposition of TiN'**
• **JOURNAL OF VACUUM SCIENCE AND**
**TECHNOLOGY. PART A. vol. 4, no. 6, November**
**1986, NEW YORK US pages 2726 - 2730 MAYR**
**AND STOCK 'Deposition of TiN and Ti(O,C,N)**
**hard coatings by a plasma assisted chemical**
**vapour deposition process'**

## Description

The present invention relates to a plasma CVD method for forming a thin film and to a semiconductor device, and more particularly to a method for forming a thin film, such as TiN film formed as a barrier layer on the inside surface of a contact hole in a semiconductor device and to the semiconductor device in which said thin film was formed.

A contact section in a semiconductor device such as LSI, has a diffusion layer on the surface of a substrate as a base, connected with an interconnection such as Al through a contact hole.

However, as LSI gets further finer and more highly integrated, a diffusion layer formed on the surface of a substrate becomes shallower. Such problems arise as in said shallow diffusion layer, Al spike occurs and destroys a connection or Si deposits on the bottom of the contact hole, which results in increasing contact resistance.

In order to solve these problems, Al alloys (e. g. Al-1%Si) previously contaminated with about 0.5-2% of Si are used as electrode connection material, but even these Al alloys are recently insufficient to prevent deposition of Si as a diameter of a contact hole is smaller than before.

Accordingly, forming a thin film called a barrier metal between Al alloy and a Si substrate for prevention of diffusion is considered. A TiN film is known as a barrier metal on account of its small electrical resistance and chemical stability (Yamanishi, Yoshihara, Kitahara, and Hosokawa; "Vacuum", Vol.30 No.5 p.347, 1987).

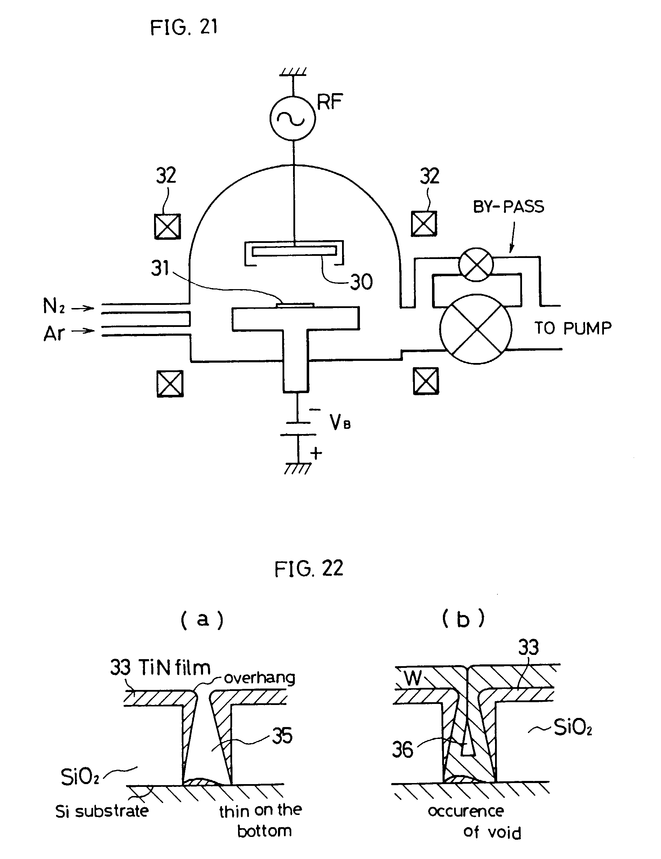

A TiN film was so far formed by Reactive Sputtering method. The Reactive Sputtering method is how to form a TiN film on a substrate 31 by using Ti as a target 30 and providing Ar and $N_2$ as sputtering gas in such a device as shown in Fig.21 (Kanamori; "Vacuum", Vol.29 No .9 p.418, 1986). Reference numeral 32 designates a coil.

However, by this method, wherein Step Coverage is poor, a TiN film is formed in the contact section as shown in Fig. 22(a). As a semiconductor device gets more highly integrated to 64MDRAM, and next to 256MDRAM, aspect ratio (=hole depth / hole diameter) of contact hole 35, becomes gradually higher. As a result, by this method almost no TiN film is formed on the bottom of a contact hole 35, so that it becomes impossible to use this method. In other words, even if in a state shown in Fig. 22(a) electrode material such as W(tungsten) or Al is filled in, a void 36 occurs inside the contact hole 35, wherein interconnection becomes easy to be broken, resulting in losing function as a barrier metal, so that it is impossible to maintain reliability of LSI devices produced.

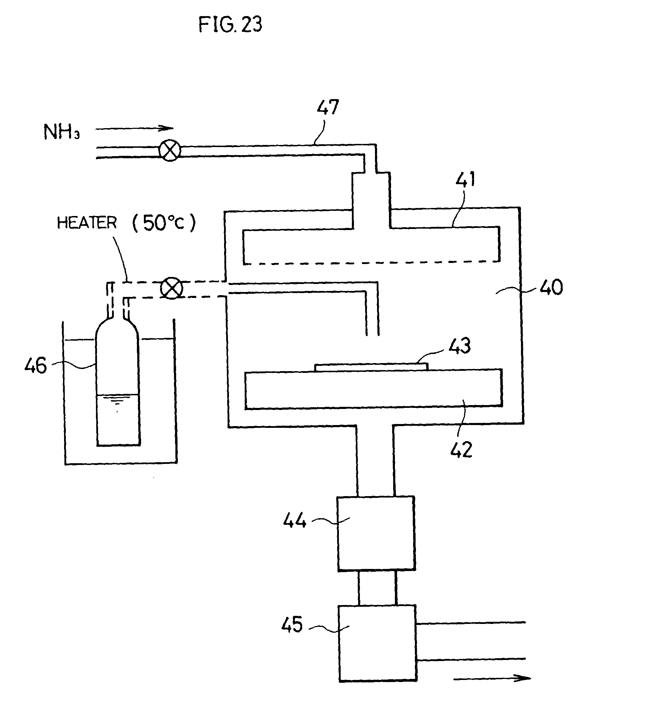

Accordingly, LPCVD method (Low Pressure Chemical Vapor Deposition method), one of thermal CVD methods, began to be known as a method for forming a thin film having good Step Coverage. This method is how to form a TiN film on a substrate by thermal reaction with using $Ticl_4$, and $NH_3$ or $N_2$ gas as materials in such a device as shown in Fig.23 (N.Yokoyama et al., Vol.136 No.3, J.Electrochem.Soc., p.882)(N.Yokoyama et al.,Vol.138 No.1, J.Electrochem. Soc., p.190).

However, as the formation of a TiN film by reaction of $Ticl_4 + N_2 + H_2$ requires high temperature of about 900~1000°C , resulting in having a bad influence on device characteristics, the method had a problem that it cannot be applied to the production of a LSI device (Arthur Sherman, Extended Abstract of the 1991 International Conference on Solid State Devices and Materials, 1991 p.177-179).

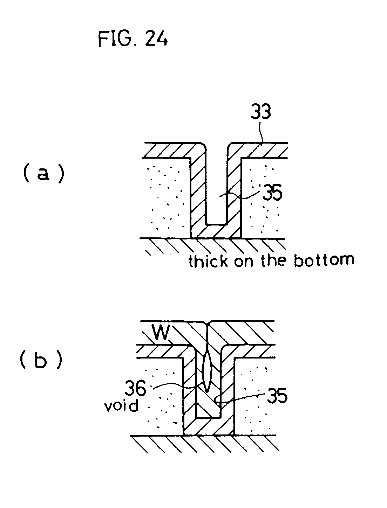

On the other hand, as reaction of $Ticl_4 + NH_3$ takes place at low temperature, a method wherein $NH_3$ gas is used was promising for forming a barrier metal for a LSI device. However, it was a problem that $Ticl_4$ and $NH_3$ forms a Complex ($Ticl_4 \cdot nNH_3$) in vapor-phase, which turns yellow powder, resulting in generation of particles (M.J.Buiting, et al., J.Electrochem.Soc., Vol.138, No.2, Feb. 1991 p.500). Besides, by the LPCVD method, a TiN film is comformally formed in a contact section as shown in Fig.24(a). In case of the formation by the LPCVD method, a TiN film 33 is sufficiently formed on the bottom of a contact hole 35, which is preferable as a barrier metal; however, simultaneously a TiN film of the same thickness as that on the bottom of the contact hole 35 is formed on the side wall of the contact hole. The formation of a thick film of TiN on the side wall like this, results in a small diameter of a hole remained in the contact hole 35; substantially it is the same situation in which a contact hole of big aspect ratio is formed. Consequently, in the next step, when W(tungsten) or Al and the like filled in, a void 36 occurs in the contact hole 35 as shown in Fig. 24(b); it is another problem so as to maintain reliability of a LSI device.

In the LPCVD method, such a device as shown in Fig.23 is used as mentioned above. Reference numeral 40 designates a chamber, wherein a gas nozzle 41 and a sample stage 42 are arranged, and on the sample stage 42, a substrate 43 is placed. The bottom of the chamber 40 is connected with a booster pump 44 and a rotary pump 45, and the gas nozzle 41 is connected with a pipe 47 for $NH_3$ gas supply.

In consideration of the above-mentioned problems, the present inventors studied to accomplish the following invention.

That is, the present invention chiefly consists of using Ar, $H_2$, and $N_2$ gas and a metallic compound gas, generating a plasma in a plasma generation chamber by action of electric field generated by a microwave and a magnetic field generated by an exciting coil arranged around, and introducing the generated plasma into a reaction chamber, resulting in forming a thin film of metal nitride on a sample placed on a sample stage.

It is an object of the present invention to provide a method for forming a thin film having good Step Coverage in a contact hole, and in addition to make thickness of a thin film formed on the side wall of a contact hole thinner than that on the bottom of the contact hole.

Moreover, it is another object of the present invention to provide a method for forming a thin film at low temperature having no bad influence on a LSI device, and in addition, producing no particles such as yellow powder.

Fig. 1 is diagrammatic sectional view showing an example of thin film formation device according to the present invention;

Fig. 2 is diagrammatic sectional view showing another example of thin film formation device;

Fig. 3 is a graph indicating the relationship between flow rate of $TiCl_4$ gas and deposition rate, and the relationship between flow rate of $TiCl_4$ gas and film resistivity;

Fig. 4 is a graph indicating the relationship between aspect ratio of a contact hole and hole bottom / hole outside surface deposition rate;

Fig. 5 is a sectional view showing the state of a TiN film formed on the inside surface of the contact hole under the conditions of $TiCl_4$ : 10SCCM and gas pressure : 173.3 mPa (1.3 mTorr);

Fig. 6 is a sectional view showing the state of a TiN film formed on the inside surface of the contact hole under the conditions of $TiCl_4$ : 10SCCM and gas pressure : 399.9 mPa (3 mTorr);

Fig. 7 is a sectional view showing the state of a TiN film formed on the inside surface of the contact hole under the conditions of $TiCl_4$ : 10SCCM and gas pressure : 666.6 mPa (5 mTorr);

Fig. 8 is a sectional view showing the state of a TiN film formed on the inside surface of the contact hole under the conditions of $TiCl_4$ : 5SCCM and gas pressure : 93.3 mPa (0.7 mTorr);

Fig. 9 (a) is a sectional view showing the state of a TiN film formed on the contact hole by the method according to the examples;

Fig. 9 (b) is a sectional view showing the state of the contact hole with W(tungsten) filled in after Fig.9 (a);

Fig. 10 is a graph indicating the relationship between film resistivity of a TiN film formed by using a plasma CVD device and substrate temperature, and the relationship between deposition rate of a TiN film and substrate temperature;

Fig. 11 is a graph indicating the relationship between film resistivity of a TiN film formed by using the plasma CVD device and microwave power, and the relationship between deposition rate of a TiN film and microwave power;

Fig. 12 is a sectional view showing the state of growth of a TiN film deposition on a Si substrate in the case of $TiCl_4$ : 10SCCM;

Fig. 13 is a sectional view showing the state of growth of a TiN film deposition on a Si substrate in the case of $TiCl_4$ : 5SCCM;

Fig. 14 is a sectional view showing the state of growth of a TiN film deposition on a Si substrate in the case of $TiCl_4$ : 15SCCM;

Fig. 15 is a sectional view showing the state of growth of a TiN film deposition on a Si substrate in the case of $TiCl_4$ : 20SCCM;

Fig. 16 is a diagram showing the result of RBS analysis of the sample which is produced by forming a TiN film on a Si substrate and evaporating Al thereon;

Fig. 17 is a diagram showing EDX spectra of a TiN film formed on Si substrate in the case of microwave power 1kW;

Fig. 18 is a diagram showing EDX spectra of a TiN film formed Si substrate in the case of microwave power 2.8 kW;

Fig. 19 is a diagram showing the result of SIMS analysis of the surface of an Si substrate on which a TiN film is formed;

Fig. 20 is an X-ray diffraction pattern of a TiN film;

Fig. 21 is a diagrammatic sectional view of a Reactive Sputtering apparatus;

Fig. 22(a) is a sectional view showing the state of a TiN film formed on the contact hole by Reactive Sputtering method;

Fig. 22(b) is a sectional view showing the state with W(tungsten) filled in after Fig. 22(a);

Fig. 23 is a diagrammatic sectional view showing the device used in the LPCVD method;

Fig. 24(a) is a sectional view showing the state of a TiN film formed on the contact hole by the LPCVD method; and

Fig. 24(b) is a sectional view showing the state with W(tungsten) filled in after Fig. 24(a).

In more detail, the present invention provides a plasma CVD method for generating a thin film, comprising the steps of: generating a plasma in a plasma generation chamber by action of an electric field generated by a microwave and a magnetic field generated by an exciting coil arranged around; and introducing the generated plasma into a reaction chamber, resulting in forming a thin film on a sample placed on a sample stage under the conditions that the pressure in the reaction chamber is less than 266 mPa (2.0 mTorr) and the temperature of said sample is more than 450°C, wherein it is a characteristic to form a metal nitride film on said sample, by introducing Ar, $H_2$, and $N_2$ gas into said plasma generation chamber, while introducing a metallic compound gas into said reaction chamber or into said plasma generation chamber.

In a preferred embodiment, said sample is a substrate for producing a semiconductor device on which an insulating film having a contact hole thereon is formed, wherein by using titanium tetrachloride gas as said metallic compound gas, a Ti nitride film is formed on the contact hole.

Further, in a preferred embodiment of the present method, the pressure in the reaction chamber is less than 173.3 mPa (1.3 mTorr).

Furthermore, it is preferred in the method of the invention that said thin film is formed with applying RF (Radio Frequency) to a microwave inlet window.

The method of the invention further includes the embodiment, wherein a $H_2$ plasma treatment is carried out after forming a Ti nitride film.

The present invention also relates to a semiconductor device, wherein the thickness of a Ti nitride film on the bottom of a contact hole is thicker than that on the side wall of said contact hole, preferably wherein the thickness of the Ti nitride film on the side wall of the contact hole is 20-60 % of that on the bottom of said contact hole.

Furthermore, the present invention relates to the use of a method as defined above for producing a semiconductor device, wherein the thickness of a Ti nitride film on the bottom of a contact hole is thicker than that on the side wall of said contact hole, preferably wherein the Ti nitride film on the side wall of the contact hole is 20-60 % of that on the bottom of said contact hole.

In other words, according to the present method described above, Ar and $H_2$ gas are supplied in a plasma generation chamber so as to accelerate the film forming, while a metallic compound gas such as $TiCl_4$ is introduced into a reaction chamber, and with passing through an exciting coil supplied direct current, a microwave is introduced in the plasma generation chamber through a wave guide and a microwave inlet window.

The microwave introduced in the plasma generation chamber activates Ar, $H_2$ and $N_2$ gas supplied in the plasma generation chamber, resulting in generating a plasma. When the generated plasma is introduced into the reaction chamber by the divergent magnetic field formed by the exciting coil, said metallic compound gas reacts on said plasma, resulting in providing metal nitride on the surface of a sample placed in the reaction chamber and forming a metal nitride film thereon.

According to another embodiment of the method described above, when Ar, $H_2$, $N_2$ gas and a metallic compound gas such as $Ticl_4$ are supplied in a plasma generation chamber, and with passing through an exciting coil supplied direct current, a microwave is introduced in the plasma generation chamber through a wave guide and a microwave inlet window, the microwave introduced in the plasma generation chamber activates Ar, $H_2$ and $N_2$ gas supplied in the plasma generation chamber, resulting in generating a plasma. When the generated plasma is introduced into the reaction chamber by the divergent magnetic field formed by the exciting coil said metallic compound gas reacts on $N_2$ and the like, resulting in providing metal nitride on the surface of a sample placed in the reaction chamber and forming a metal nitride film thereon.

As the reaction mechanism of the metal nitride film formation, the following reaction equation is considered.

$$2\,TiCl_4 + N_2 + 4\,H_2 \rightarrow 2\,TiN + 8\,HCl \uparrow$$

In order to completely decompose $TiCl_4$ to Ti + Cl, very high energy of more than 1,674.8 kJ(400Kcal) $mol^{-1}$ is required.

In the method according to the present invention, by making resonance such as plasma CVD, especially electron cyclotron resonance excitation (ECR) plasma CVD occur, high energy electrons are produced, and by collision of these electrons; reactions of decomposition and reduction are enhanced.

Accordingly, without high sample temperature such as 900 ~ 1000 °C, a metal nitride film is formed on the surface of the sample.

Ar is introduced in order to stabilize plasma discharge, and when RF is applied to the microwave inlet window in order to prevent a conductivity film from depositing on said window, Ar also acts as a sputtering gas of the conductivity film.

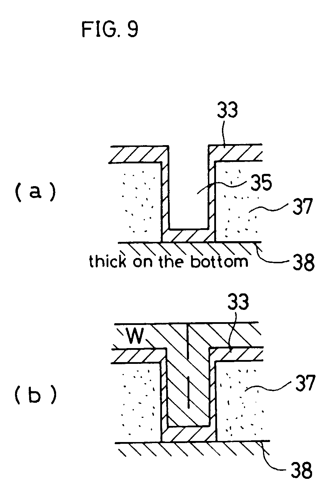

In the method according to the present invention, the generated plasma is supplied to the sample with good directivity, so that a metal nitride film is formed in the contact hole 35 as shown in Fig.9(a). Consequently, in the next step, when interconnection material such as W or Al is plugged up in the contact hole 35, no voids occur and plugging up is carried out as shown in Fig.9(b), resulting in achievement of flattening interconnection.

Example 1

In this example, by the plasma CVD method, the case of forming a thin film of TiN on samples having holes of different aspect ratio on the surface is described.

The plasma CVD apparatus used for forming a thin film according to this example comprises a main body 3 comprising a plasma generation chamber 1 and a reaction chamber 2, an exciting coil 4 arranged around the plasma generation chamber 1 and connected with a direct current power source (not shown), a wave guide 5 introducing a microwave generated from a microwave generator (not shown) into the plasma generation chamber 1, and so on. Reference numeral 6 designates a microwave inlet window comprising a quarty glass etc., reference numeral 7 designates a radio frequency generator to apply to a radio frequency (RF) power supply on the microwave inlet window, and reference numeral 8 designates a sample stage on which a sample 9 is placed.

The plasma generation chamber 1, formed in mostly cylindrical shape with the first opening 10 for introducing a microwave formed almost at a center of the upper wall thereof , and below the plasma generation chamber 1, a reaction chamber 2 having larger diameter than the plasma generation chamber 1, are formed in one body. The reaction chamber 2 and the plasma generation chamber are devided by a diaphragm 11 with the second opening (for plasma extraction) 12 formed almost at a center thereof.

In addition, at the side wall of the reaction chamber 2 the first guide pipe 13 is connected, at the bottom of the reaction chamber 2 an exhaust pipe 14 connected with exhaust system (not shown) is connected. At the upper wall of the plasma generation chamber 1, the second guide pipe 15 is connected.

High frequency generation source 7 comprises a high frequency oscillator 16 and a matching box 17, a flat electrode 18 inserted between the microwave inlet window 6 and the wave guide 5, RF is applied to the microwave inlet window 6. The sample stage 8 is connected with a RF radio frequency oscillator 21 for applying RF radio frequency to the sample 9 through a matching box 20. Applying the prescribed radio frequency to the sample 9 by the radio frequency oscillator 21, and operating the above-mentioned method for forming a thin film, makes it possible to form a thin film having good Step Coverage even in case of high aspect ratio.

Heating the sample 9 by a fixed heater and the like and keeping the temperature of the sample 9 at the prescribed degree, such as 200 $\sim$ 600 °C, results in accelerating crystallization of a formed thin film and low film resistivity of the thin film.

When the exciting coil 4 is supplied with direct current, the definite magnetic field is produced in the plasma generation chamber 1. As a result, it is possible to form such a magnetic field as angle frequency $\omega$ of a microwave introduced from the microwave oscillator into the plasma generation chamber 1 and angle frequency $\omega_c$ of electron cyclotron are equal in the plasma formation chamber 1, making the electrons do resonance movement. The condition under which said resonance is produced, that is ECR condition is easily determined by solving the following classical dynamic formula.

$$\omega = \omega_c = eB/m... \qquad ①$$

Here, e represents charge of electron ( $=1.6 \times 10^{-19}$C), B represents magnetic flux density (T), and m represents mass of electrons($=9.1 \times 10^{-31}$ kg).

In this example angle frequency $\omega$ of a microwave was established at 2.45 GHz, and by said formula① magnetic flux density B to fulfill the ECR condition was established at $8.75 \times 10^{-2}$ T.

In order to form a thin film by using said apparatus, firstly by operating exhaust system the pressure in the main body 3 was reduced to less than $133.3 \times 10^{-6}$ Pa ($1 \times 10^{-6}$ Torr), after that, while $TiCl_4$ is supplied at a flow rate of 5 $\sim$ 15 SCCM into the reaction chamber 2 through the first guide pipe 13, Ar at a flow rate of 43 SCCM, $N_2$ at a flow rate of 15 SCCM, and $H_2$ at a flow rate of 50 SCCM, were supplied into the plasma generation chamber 1 through the second guide pipe 15. After that, the pressure in the main body 3 was established in the prescribed pressure, such as 266.6 mPa ($2 \times 10^{-3}$ Torr).

Moreover, turning on electricity in the radio frequency generation source 7 and applying voltage to the microwave inlet window 6, made sputtering effect by RF, by which a thin film of TiN was prevented from deposition on the microwave inlet window 6.

On the other hand, introducing a microwave of 800W from the microwave oscillator through the wave guide 5 into the plasma generation chamber 1, while connecting the exciting coil 4 with the direct current source, resulted in forming a magnetic field in the plasma generation chamber 1. Then making high energy electrons collide with material gas, which was activated to be ionized, resulting in generating a plasma.

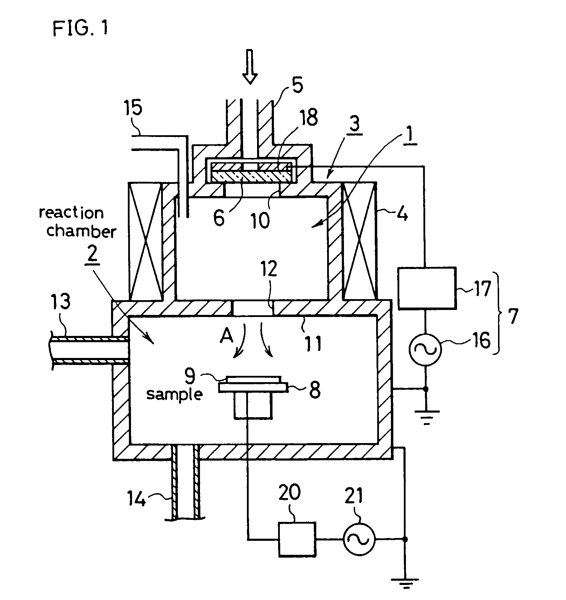

Next, the plasma passed through the second opening 12, introduced into the reaction chamber 2 with acceleration by the divergent magnetic field to the direction of an arrow A in Fig.1, and formed a thin film of TiN on the surface of the sample 9 having a hole with aspect ratio of 0.2 $\sim$ 1.0 placed on the sample stage 8.

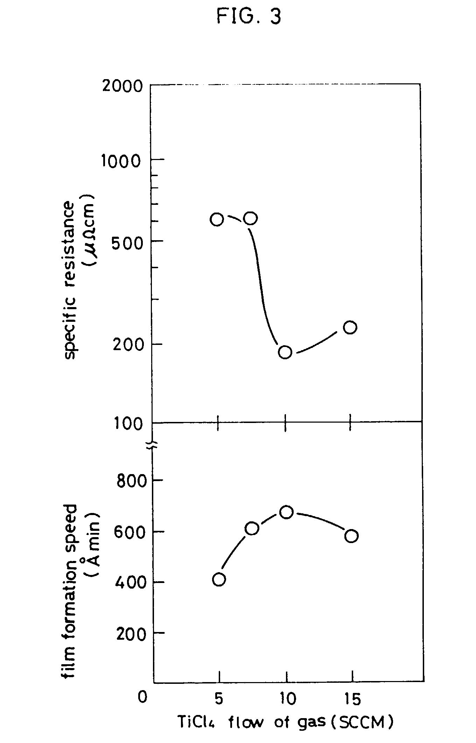

The relationship between flow rate of $TiCl_4$ gas and film forming speed, and the relationship between flow rate of $TiCl_4$ gas and film resistivity obtained in this example was show in Fig. 3. As obvious from the Fig. 3, at gas flow rate of 10 SCCM, film forming speed of 70.0 nm (700Å) /min and film resistivity of 180$\mu$ $\Omega$ cm were obtained.

Example 2

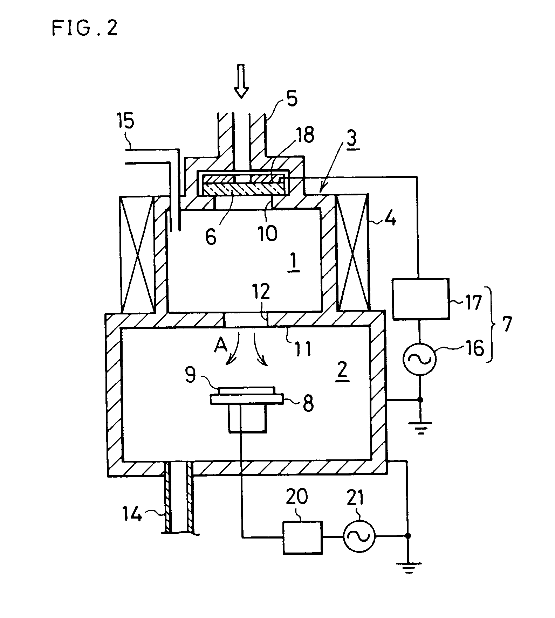

Fig. 2 is a diagrammatic sectional view showing another plasma CVD apparatus used for the method of forming a thin film according to the present invention.

As only one constructual difference of this plasma apparatus from the plasma apparatus in the example 1 is having no first guide pipe 13 connected at the side wall of the reaction chamber 2, and the other compositions are the same as the plasma apparatus in the example 1, the detailed explanation is omitted.

In order to form a thin film by using said plasma apparatus, at first, Ar, $H_2$ , $N_2$ gas and a metallic compound gas, $TiCl_4$ gas are introduced in the second guide pipe 15 connected with the plasma generation chamber 1.

The plasma gas formed by the action of the electric field generated the microwave introduced through the wave guide 5 into the plasma generation chamber 1 and the magnetic field generated by the exciting coil 4, is introduced into the reaction chamber 2 by the divergent magnetic field generated by the exciting coil 4. And the plasma gas is provided on the surface of the sample 9, on which a TiN film is formed.

In this example, flow rate of Ar gas was 43 SCCM, that of $N_2$ gas was 15 SCCM, that of $H_2$ gas was 50 SCCM, and that of $TiCl_4$ gas was 10 SCCM; and temperature of the sample 9 was 600°C .

Also in this example, almost the same film forming speed was obtained as that in case of $TiCl_4$ gas flow rate of 10 SCCM shown in Fig. 3.

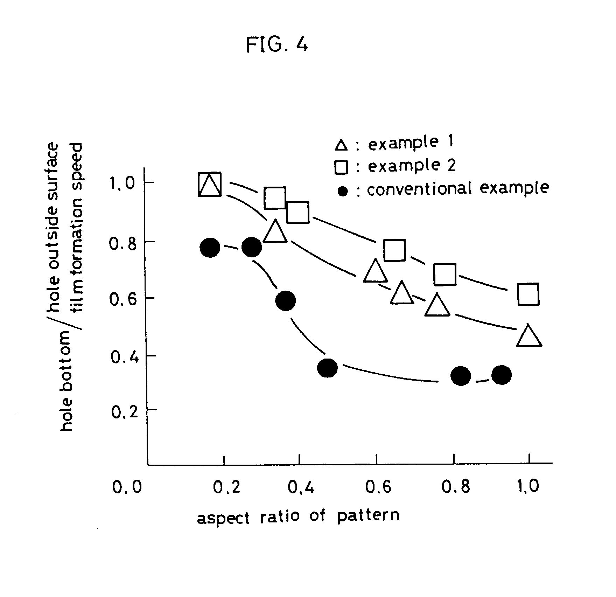

In Fig. 4, contrasted the examples 1,2 and the result of the experiment disclosed in Japanese Patent Laid-Open Publication No.3072/90 as a prior art, the relationship between aspect ratio and hole bottom / hole outside surface film forming speed is shown. It is obvious from Fig. 4 that at high aspect ratio, hole bottom / hole outside surface film forming speed is excellent.

Example 3

Next, an insulating film of $SiO_2$ was formed on a P-type Si substrate, wherein a contact hole was formed; by using the apparatus shown in Fig. 1 with the substrate as a sample, a thin film of TiN was formed on the inside surface of the contact hole.

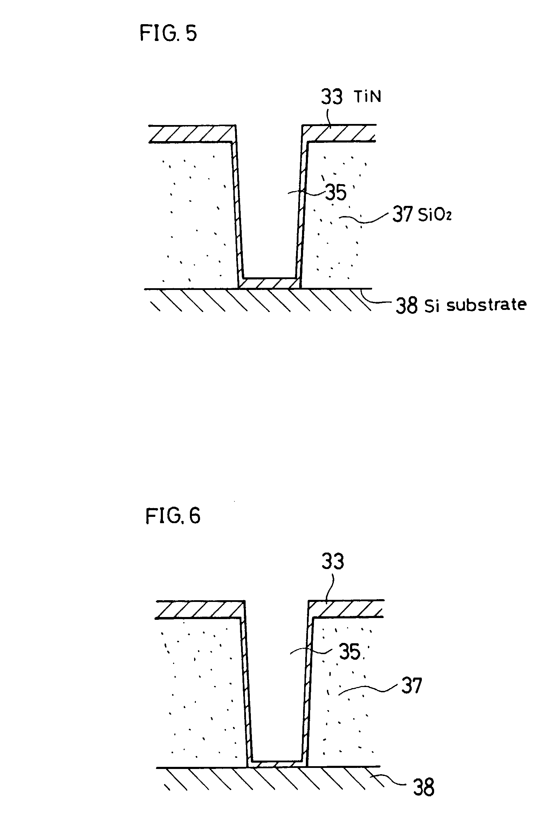

At first, by operating exhaust system the pressure in the main body 3 was reduced to $133.3 \times 10^{-6}$ Pa ($1 \times 10^{-6}$ Torr), after that, while $TiCl_4$ gas flow rate of 10 SCCM was supplied through the first guide pipe 13 into the reaction chamber 2, Ar: 43 SCCM, $H_2$: 50 SCCM, and $N_2$: 15 SCCM were supplied through the second guide pipe 15 into the plasma generation chamber 1. Under these conditions with changing gas pressure in the apparatus, the state of the TiN film formation especially the state of deposition of TiN film on the inside surface of the contact hole was investigated. As a result, at less than 266 mPa (2.0 mTorr) the state of deposition was satisfactory, but at gas pressure of more than that unsatisfactory. A diagram based on the photomicrograph of the SEM scanning electron microscope, wherein a TiN film actually deposited on the inside surface of the contact hole of aspect ratio 2, is show in Fig. 5. The deposition conditions were gas pressure 173.3 mPa (1.3 mTorr), microwave power 2.8kW, substrate temperature 550°C , $TiCl_4$ : 10 SCCM, $H_2$ : 50 SCCM, $N_2$ : 15 SCCM, and Ar: 43 SCCM.

It is regarded from Fig. 5 that a TiN film 33 deposisited on the side wall and bottom of the contact hole 35. The film thickness on the bottom was about 50.0-60.0 nm (500 ~ 600 Å), and that on the side wall was 20.0-30.0 nm (200 ~ 300 Å), while that on the insulating film was 100.0 nm (1000Å). In other words, the thickness of film forming on the bottom of the contact hole 35 could be over 50 % of that on the substrate surface.

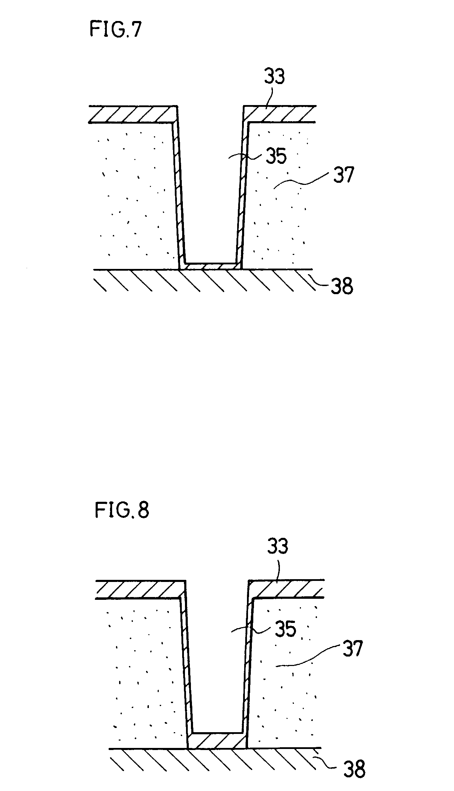

As comparative examples, diagrams based on the photomicrograph of SEM, wherein at pressure in the main body 3 of 399.9 mPa (3 mTorr) and 666.6 mPa (5 mTorr), the other deposition conditions were the same, are shown in Figs. 6 and 7. Under these conditions, the state of sufficient deposition was not obtained.

Example 4

The diagram based on the photomicrograph of SEM in Fig. 8, shows the state of film formation under such conditions as pressure 93.3 mPa (0.7 mTorr), $TiCl_4$: 5 SCCM, Ar:$H_2$: 50 SCCM, $N_2$ : 15 SCCM, microwave power 2.8kW, and substrate temperature 550 °C . It is obvious from this diagram that the thickness of film forming on the bottom of the contact hole 35 was 70 % of that on the substrate surface, very excellent percentage.

As obvious from Figs. 3 and 4, it is desirable that pressure in the main body 3 is set up at 266 mPa (2.0 mTorr), preferably less than 173.3 mPa (1.3 mTorr).

The plasma CVD method according to the present invention comprises activating gas by turning it into a plasma, introducing the activated gas along divergent magnetic flux line onto the sample, and forming a TiN film thereon. Accordingly, the activated gas molecules have orientation because of induced by the divergent magnetic field, and are irradiated on the sample almost vertically, resulting in that the TiN film on the surface of the insulation around the contact hole and on the bottom of that gets thick, while the TiN film on the side wall of the contact hole gets thin. Since the TiN film is thick on the bottom of the contact hole, it has good barrier characteristic, while since the TiN film is thin on the side wall of the contact hole, the diameter of the contact hole doesn't get so small, resulting in not so high aspect ratio after the TiN film forming. As a result, in the next step, wherein electrode materials Al and W(tungsten) are filled in, the probability of forming voids decreases, resulting in that highly reliable interconnection is possible.

In Fig. 9(a), the state of the TiN film 33 deposition arround the contact hole 35 by the plasma CVD method according to the present invention is shown, and later, the state after filling in with W(tungsten) is shown in Fig. 9(b). In addition, in Table 1, data of the film thickness formed by each film formation is shown.

Table 1

| | Reactive Sputtering method | LPCVD method | E C R plasma C V D method | | |
|---|---|---|---|---|---|
| | | | (5mTorr) 666.6 mPa | (1.3mTorr) 173.3 mPa | (0.7mTorr) 93.3 mPa |
| film thickness on Si substrate | (1000 Å) 100.0 nm | (1000 Å) 100.0 nm | (1000 Å) 100.0 nm | (1000 Å) 100.0 nm | (1000 Å) 100.0 nm |
| film thickness on the side wall of the contact hole | (200 Å) 20.0 nm | (1000 Å) 100.0 nm | (100 Å) 10.0 nm | (250 Å) 25.0 nm | (250 Å) 25.0 nm |
| film thickness on the bottom of the contact hole | (35 Å) 3.5 nm | (1000 Å) 100.0 nm | (300 Å) 30.0 nm | (500 Å) 50.0 nm | (700 Å) 70.0 nm |
| barrier characteristic | × | ○ | △ | ○ | ○ |
| void occurrence when tungsten filled in | × Because of much overhang on the upper | × As the actual aspect ratio is 3/1 | ○ The reason why the barrier characteriatics gets a | ○ | ○ |
| ○ no voids occur ×  voids occur | corners, little tungsten can enter the hole | , it is dif ficult for tu ngsten to be filled in the hole. | little worse seems to be that the film thickness on bottom became thin (300 Å) 30.0 nm | | |

As described above, by the ECR plasma CVD method, a film formed on the bottom is thick, and in addition, in the next step of filling in with tungsten no voids occurs.

Example 5

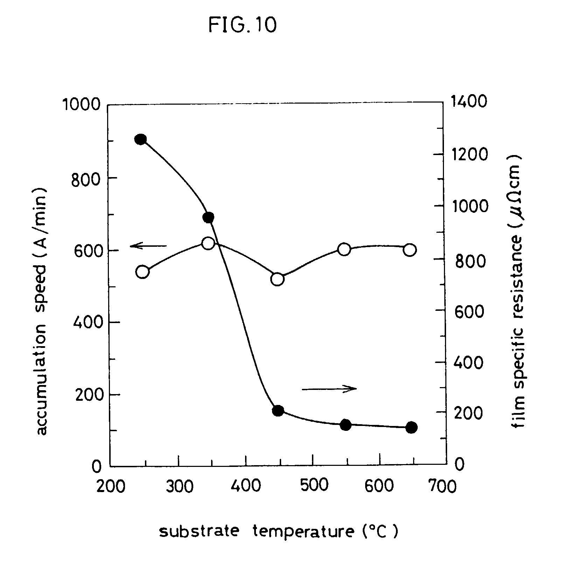

A curve written with (●) in Fig. 10 indicates the relationship between the film resistivity of a thin film formed at microwave power 1kW, gas pressure 173.3 mPa (1.3 mTorr) in the above-mentioned CVD apparatus and temperature of the substrate. That is, at the substrate temperature of more than 450°C, the film resistivity of a formed TiN film in

comparison with 523 $\mu \Omega$ cm, the value obtained by the LPCVD method described in a prior art, became less than 200 $\mu \Omega$ cm, a very small value, which is a very excellent value in view of the function of electrically connecting the diffusion layer part and the electrode part of metal interconnection in the semiconductor device. On the contrary, when the substrate temperature is less than 450°C , the film resistivity value of the formed TiN film abruptly increases, resulting in making the TiN film unsuitable for use.

Besides, a curve written with ○ in the Fig. 10 indicates the relationship between the forming speed of a TiN film and the substrate temperature under the conditions of microwave power 1kW and gas pressure 173.3 mPa (1.3 mTorr). The curve says that there is no special correlation between both of them. Consequently, it is better to keep the temperature of the substrate at more than 450°C, preferably 550°C .

Example 6

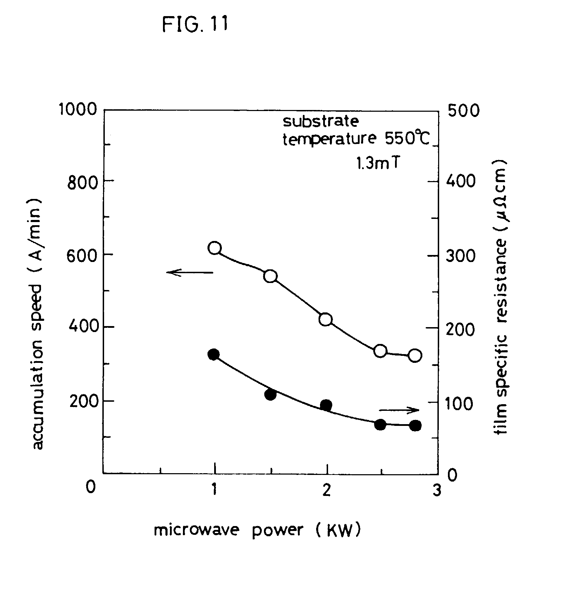

Fig. 11 indicates the relationship between microwave power and film forming speed (○) and that between microwave power and film resistivity (●). It was comfirmed from Fig. 11 that the specific resistance of less than 200$\mu \Omega$ cm at the microwave power of more than 1kW, and less than 100 $\mu \Omega$ cm at more than 2kW are obtained.

These results indicate that compared with the film resistivity 525$\mu \Omega$ cm obtained by the LPCVD method of a prior art wherein only thermal reaction is used, the method according to the present invention, wherein both thermal reaction energy and plasma energy are used, is further excellent and that it is possible to achieve to the practical use level.

EXAMPLE 7

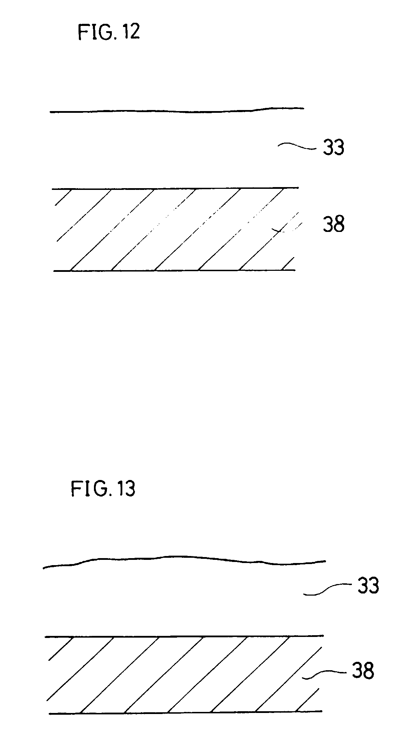

The diagrams based on the photomicrograph of SEM of a TiN film deposoted on the contact hole are shown in Figs. 12 ~ 15.

The deposition conditions are microwave power 1kW and the same as the deposition conditions shown in Fig. 5, except changing the flow rate of $TiCl_4$ gas. It was comfirmed from this Fig. 12 that the deposited TiN film doesn't have column structure but homogenous fine structure. Accordingly, it was expected that it has a good barrier characteristic.

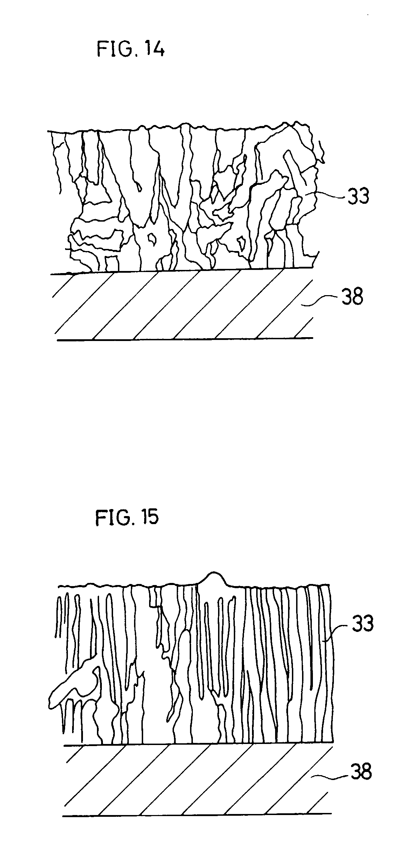

The cases of $TiCl_4$: 5 SCCM, $TiCl_4$: 15 SCCM, and $TiCl_4$ : 20 SCCM are shown in Figs. 13, 14,and 15 respectively, which presents the change of the structure of the TiN Film was caused by changing the flow of $TiCl_4$. In Figs. 14 and 15, the TiN film has column structure, while the TiN film in Fig. 13 has homogenous fine structure as well as that in Fig.12.

In the case of constant microwave power, as mentioned above, with increasing the flow rate of $TiCl_4$ gas, the structure of the TiN film tends to be column, while in the case of increasing microwave power, even with the large flow rate of $TiCl_4$ gas, the structure of the TiN film can be homogenous and fine.

Next, the result of investigation of the relationship between microwave power, flow rate of $TiCl_4$ gas and structure of a TiN film.

Table 2

| | | flow rate of $TiCl_4$ (SCCM) | | | |
|---|---|---|---|---|---|
| | | 5 | 10 | 15 | 20 |
| microwave power (kW) | 1 | ○ | ○ | × | × |
| | 1.5 | ○ | ○ | △ | × |
| | 2.0 | ○ | ○ | ○ | × |
| | 2.5 | ○ | ○ | ○ | △ |
| | 2.8 | ○ | ○ | ○ | ○ |
| ○ : no cylindrical construction / barrier characteristic good | | | | | |
| △ : some cylindrical construction occurs / barrier characteristic unstable | | | | | |
| × : cylindrical construction occurs / barrier characteristic bad | | | | | |

It was regarded from this result that even if flow rate of $TiCl_4$ gas increased, correspondingly increasing microwave power can prevent occurence of column structure.

Example 8

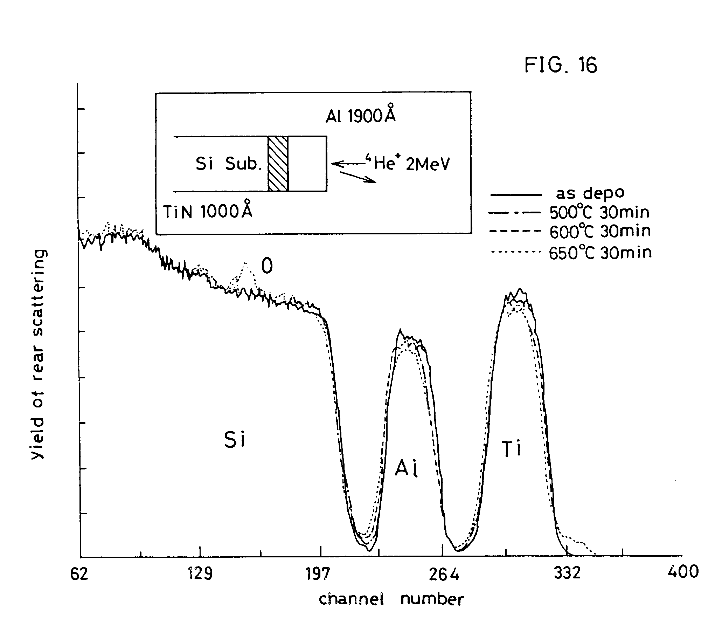

the result of the experiment showing the barrier characteristic is excellent, is shown in Fig. 16, wherein the curves of Al and Ti don't expand horizontally.

Fig. 16 is a graph indicating the result of analysis four samples as follows by RBS (Rutherford Backscattering Spectroscopy);

a TiN film of 100.0 nm (1000Å) formed on a Si substrate, with Al deposited thereon, (1) unheated, (2) heated at 500 °C for 30 minutes, (3) at 600 °C for 30 minutes, and (4) at 650°C for 30 minutes. RBS comprises the steps of irradiating He atoms of a definite energy on the substrate, and by the energy of the reflecting He investigating the element distribution to the direction of the film thickness in the film. The energy loss of He which collided with every element is determined by element (atomic weight), that is, the lighter the element is, the lighter it goes. Accordingly, although the film construction is Al/TiN/Si, the peaks come in the order of Si, Ti, and Al. Besides, the width of each peak corresponds to the film thickness, so that a wide peak means diffusion (as Si is a substrate and wide, only the one side can be seen). It is obvious from Fig. 16 that the peaks make almost no change by heat treatment, and that even after the heat treatment at 650°C for 30 minutes, it shows high barrier characteristic (effect of preventing diffusion).

A diagram at the upper part in the frame indicates that in the film structure Al/TiN/Si, He was irradiated from the direction of Al, and the yield of He ions scattering backward was measured.

In the next step after forming a TiN film, wherein the interconnection of W alloy or Al or Al alloy such as Al-Si-Cu is done on the TiN film, when chlorine remains in the TiN film, the interconnection of Al and the like is heavily corroded by the chlorine. In some cases, $AlCl_3$ insulating film is produced, resulting in the corrosion of the Al interconnection to the extent to which it is observed with the naked eye. Therefore, it is an indispensable step to decrease chlorine from a TiN film as much as possible.

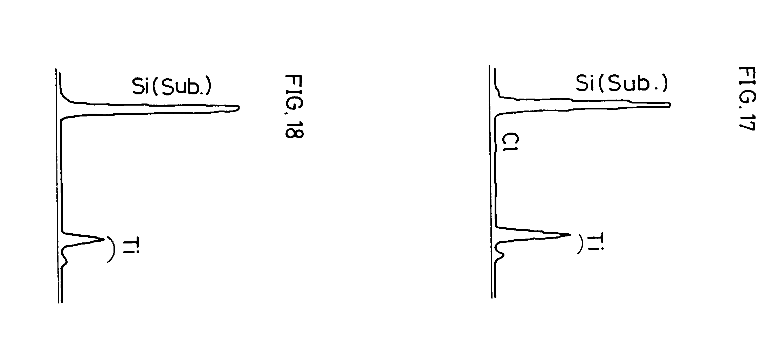

Figs. 17 and 18 shows the EDX (Energy Dispersion-type X-ray analyzer) spectra of the TiN films formed at the microwave power of 1kW and 2.8kW, under the same deposition conditions as those in the examples according to the present invention. At the microwave power of 1kW, the peak of chlorine Cl was noticed, while at 2.8kW no peak of chlorine Cl was noticed.

Thus the contamination of chlorine Cl can be checked by enhancing the microwave power. In addition, chlorine Cl can be reduced by the $H_2$ plasma treatment after the TiN film formation.

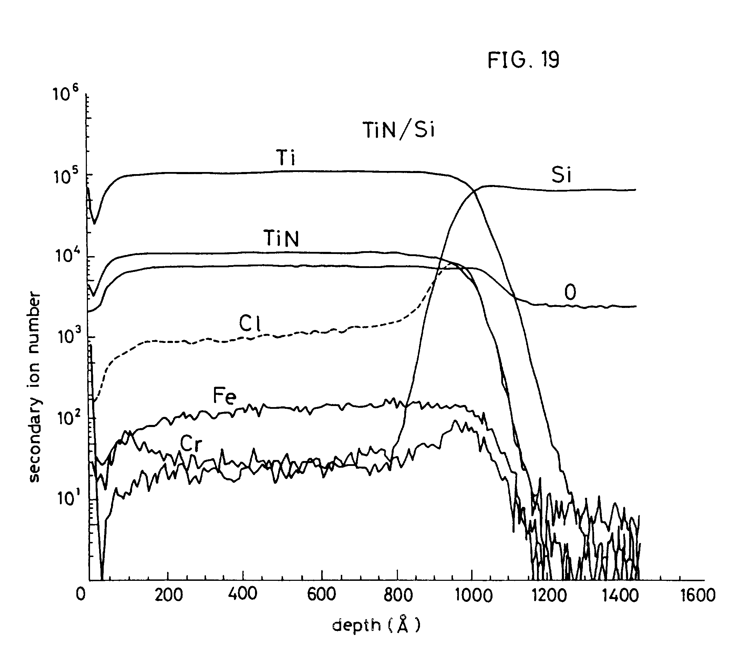

Fig. 19 indicates the result analyzed by SIMS (Secondary Ion Mass Spectroscopy) from the surface of the sample given the $H_2$ plasma treatment after the TiN film formation to the direction of depth (vertically to TiN film toward the Si substrate).

The SIMS comprises the steps of digging the film to the direction of depth by irradiating oxygen ions and measuring the distribution of elements or molecules (e.g. TiN) existing in the direction of the depth. In other words, irradiating the high energy oxygen ions so that materials in the film are expelled, and analysing the signal strength of the ions (the secondary ions) in the direction of depth.

In Fig. 19, the left side (on the vertical axis) is the surface side of a TiN film, and as going to the right, the depth digged down becomes bigger. On the surface of the film, chlorine was reduced by the $H_2$ plasma treatment after the TiN film formation.

Thus, by the $H_2$ plasma treatment, chlorine concentration on the surface of the TiN film can be reduced, resulting in preventing the corrosion of Al interconnection and the like by chlorine. The $H_2$ plasma treatment is to stop supplying Ti compound gas such as $TiCl_4$ and $N_2$ gas at the end of the treatment of the TiN film formation, and to supply Ar gas and $H_2$ gas in order to keep the state wherein a plasma is produced.

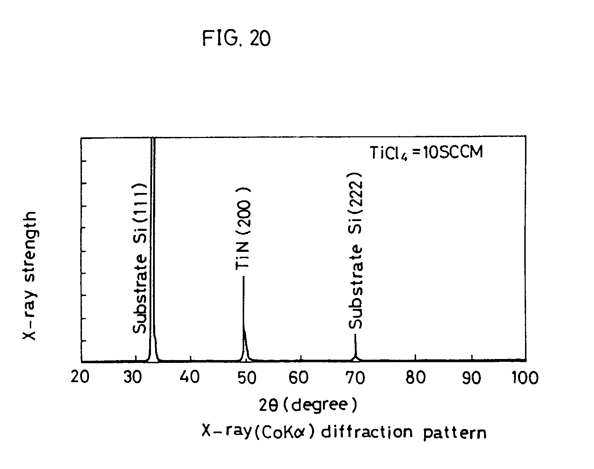

Next, X-ray diffraction pattern of TiN film formed by the method according to the example is shown in Fig. 20. The pattern diagram indicates the crystal of TiN oriented on the Si substrate (111) only in the direction (100). The deposition conditions were microwave power 1kW, substrate temperature 550°C, flow of $N_2$: 15 SCCM, $H_2$: 50 SCCM, and Ar: 43 SCCM.

(100) oriented film has an excellent barrier characteristic, and it is guessed that extremely strong (100) orientation of a TiN film formed by the method according to the example may be based on the directionality of a plasma.

As obvious from the above-mentioned explanations, by the method for forming a thin film according to the present invention, it is capable of forming a metal nitride film having good Step Coverage, and forming a thin film sufficiently keeping a barrier characteristic on the contact hole, even if a LSI device gets more highly integrated and aspect ratio of the contact hole formed on a insulation layer becomes bigger.

In addition, the film thickness of the thin film formed on the side wall of the contact hole can be made thinner than that on the bottom of the contact hole, and with keeping a barrier characteristic on the bottom of the contact hole, aspect ratio of the contact hole after forming a thin film can be refrained from enhanced. Accordingly, in the following step of filling in with interconnection materials, no voids occur in the contact hole, resulting in preventing interconnection from broken and improving reliability of a LSI device.

Besides, it is possible to form a thin film at such low temperature as no bad influence is given on producing a LSI device, and in addion, with no particles such as yellow powder produced, to produce further reliable LSI devices.

## Claims

1. A plasma CVD method for generating a thin film, comprising the steps of:

   generating a plasma in a plasma generation chamber by action of an electric field generated by a microwave and a magnetic field generated by an exciting coil arranged around; and
   introducing the generated plasma into a reaction chamber, resulting in forming a thin film on a sample placed on a sample stage under the conditions that the pressure in the reaction chamber is less than 266 mPa (2.0 mTorr) and the temperature of said sample is more than 450°C, wherein it is a characteristic to form a metal nitride film on said sample, by introducing Ar, $H_2$, and $N_2$ gas into said plasma generation chamber, while introducing a metallic compound gas into said reaction chamber or into said plasma generation chamber.

2. The method according to claim 1, wherein said sample is a substrate for producing a semiconductor device on which an insulating film having a contact hole thereon is formed, wherein by using titanium tetrachloride gas as said metallic compound gas, a Ti nitride film is formed on the contact hole.

3. The method according to claims 1 or 2, wherein the pressure in the reaction chamber is less than 173.3 mPa (1.3 mTorr).

4. The method according to claims 1 to 3, wherein said thin film is formed with applying RF (Radio Frequency) to a microwave inlet window.

5. The method according to claims 1 or 2, wherein a $H_2$ plasma treatment is carried out after forming a Ti nitride film.

6. A semiconductor device, wherein the thickness of a Ti nitride film on the bottom of a contact hole is thicker than that on the side wall of said contact hole.

7. The semiconductor device according to claim 6, wherein the thickness of the Ti nitride film on the side wall of the contact hole is 20 - 60 % of that on the bottom of said contact hole.

8. The use of a method according to claims 1-5 for producing a semiconductor device, wherein the thickness of a Ti nitride film on the bottom of a contact hole is thicker than that on the side wall of said contact hole.

9. The use according to claim 8, wherein the Ti nitride film on the side wall of the contact hole is 20-60 % of that on the bottom of said contact hole.

## Patentansprüche

1. Plasma-CVD-Verfahren zur Erzeugung eines Dünnfilms, umfassend die Schritte:

   Erzeugen eines Plasmas in einer Plasmaerzeugungskammer durch die Wirkung eines durch eine Mikrowelle erzeugten, elektrischen Felds und eines durch eine darum herum angeordnete Erregerspule erzeugten Magnetfelds; und
   Einführen des erzeugten Plasmas in eine Reaktionskammer, wodurch die Bildung eines Dünnfilms auf einer auf einem Probenständer angeordneten Probe unter den Bedingungen resultiert, daß der Druck in der Reaktionskammer weniger als 266 mPa (2,0 mTorr) und die Temperatur der Probe mehr als 450°C beträgt, wobei es ein Charakteristikum ist, einen Metallnitridfilm auf der Probe auszubilden, durch Einführen von Ar, $H_2$ und $N_2$-Gas in die Plasmaerzeugungskammer, während ein Gas einer metallischen Verbindung in die Reaktionskammer oder in die Plasmaerzeugungskammer eingeführt wird.

2. Verfahren nach Anspruch 1, wobei die Probe ein Substrat zur Herstellung einer Halbleitereinrichtung ist, auf dem ein Isolationsfilm mit einem Kontaktloch darauf gebildet wird, wobei durch Verwendung von Titantetrachlorid-Gas als Gas einer metallischen Verbindung ein Ti-Nitridfilm auf dem Kontaktloch ausgebildet wird.

3. Verfahren nach Anspruch 1 oder 2, wobei der Druck in der Reaktionskammer weniger als 173,3 mPa (1,3 mTorr) beträgt.

4. Verfahren nach den Ansprüchen 1 bis 3, wobei der Dünnfilm unter Anwendung von RF (Radiofrequenz) auf ein Mikrowellen-Einlaßfenster gebildet wird.

5. Verfahren nach den Ansprüchen 1 oder 2, wobei eine $H_2$-Plasmabehandlung nach Ausbildung eines Ti-Nitridfilms durchgeführt wird.

6. Halbleitereinrichtung, bei der die Dicke eines Ti-Nitridfilms auf dem Boden eines Kontaktlochs dicker ist als die auf der Seitenwand des Kontaktlochs.

7. Halbleitereinrichtung nach Anspruch 6, wobei die Dicke des Ti-Nitridfilms auf der Seitenwand des Kontaktlochs 20-60 % derjenigen auf dem Boden des Kontaktlochs beträgt.

8. Verwendung eines Verfahrens nach den Ansprüchen 1-5 zur Herstellung einer Halbleitereinrichtung, wobei die Dicke eines Ti-Nitridfilms auf dem Boden eines Kontaktlochs dicker ist als auf der Seitenwand des Kontaktlochs.

9. Verwendung nach Anspruch 8. wobei der Ti-Nitridfilm auf der Seitenwand des Kontaktlochs 20-60 % derjenigen auf dem Boden des Kontaktlochs beträgt.

## Revendications

1. Procédé de dépôt en phase vapeur par voie chimique à plasma, pour générer un film mince, comprenant les étapes consistant :

   à générer un plasma dans une chambre de génération de plasma, par action d'un champ électrique généré par des micro-ondes, et d'un champ magnétique généré par une bobine excitatrice disposée autour ; et à introduire le plasma généré dans une chambre réactionnelle, pour résulter en la formation d'un film mince sur un échantillon disposé sur un support d'échantillon, dans des conditions telles que la pression dans la chambre réactionnelle soit inférieure à 266 mPa (2,0 mtorrs) et que la température de l'échantillon soit supérieure à 450 °C, caractérisé en ce qu'un film de nitrure de métal est formé sur l'échantillon par introduction d'un gaz à base de Ar, $H_2$ et $N_2$ dans la chambre de génération de plasma, et en introduisant un gaz de composé métallique dans la chambre réactionnelle ou dans la chambre de génération de plasma.

2. Procédé selon la revendication 1, dans lequel l'échantillon est un substrat pour la production d'un dispositif à semi-conducteur, sur lequel un film isolant comportant un trou de contact est formé, et dans lequel en employant du tétrachlorure de titane gazeux comme gaz de composé métallique, un film de nitrure de titane se forme sur le trou de contact.

3. Procédé selon la revendication 1 ou 2, dans lequel la pression dans la chambre réactionnelle est inférieure à 173,3 mPa (1,3 mtorrs).

4. Procédé selon les revendications 1 à 3, dans lequel le film mince est formé par application de radiofréquences (RF) à une fenêtre d'entrée de micro-ondes.

5. Procédé selon la revendication 1 ou 2, dans lequel on effectue un traitement par plasma de $H_2$ après formation d'un film de nitrure de titane.

6. Dispositif à semi-conducteur, dans lequel l'épaisseur du film de nitrure de titane formé au fond d'un trou de contact, est supérieure à celle sur la paroi latérale de ce trou de contact.

7. Dispositif à semi-conducteur selon la revendication 6, dans lequel l'épaisseur du film de nitrure de titane sur la paroi latérale du trou de contact, est de 20 à 60 % de celle au fond du trou de contact.

8. Utilisation d'un procédé selon les revendications 1 à 5 pour produire un dispositif à semi-conducteur, dans lequel l'épaisseur du film de nitrure de titane au fond d'un trou de contact, est supérieure à celle sur la paroi latérale de ce trou de contact.

9. Utilisation selon la revendication 8, dans lequel l'épaisseur du film de nitrure de titane sur la paroi latérale du trou de contact, est de 20 à 60 % de celle au fond de ce trou de contact.

FIG. 1

reaction chamber

sample

FIG.2

FIG. 3

FIG. 4

FIG. 5

33 TiN

35

37 SiO₂

38 Si substrate

FIG. 6

33

35

37

38

FIG.7

FIG.8

FIG. 9

(a)

33

35

37

thick on the bottom

38

(b)

W

33

37

38

FIG. 10

FIG. 11

FIG. 12

~ 33

38

FIG. 13

~ 33

~ 38

FIG. 14

FIG. 15

FIG. 16

Al 1900Å

Si Sub.

$^4$He$^+$ 2MeV

TiN 1000Å

as depo
500°C 30min
600°C 30min
650°C 30min

yield of rear scattering

O

Si

Al

Ti

62        129        197        264        332        400

channel number

EP 0 483 669 B1

FIG. 17

FIG. 18

FIG. 19

EP 0 483 669 B1

FIG. 20

X-ray(CoKα) diffraction pattern

FIG. 21

FIG. 22

( a )                          ( b )

FIG. 23

FIG. 24

(a)

33

35

thick on the bottom

(b)

W

36
void

35